# EUROPEAN PATENT APPLICATION

(11) **EP 4 739 078 A1**
(43) Date of publication of application: **06.05.2026**
(21) Application number: 25211981.3
(22) Date of filing: 29.10.2025
(51) Int. Cl.: H10W 72/00, H10W 72/50

(54) **A METHOD OF MANUFACTURING A SEMICONDUCTOR DEVICE**

(30) Priority: 29.10.2024 NL 2038947
(71) Applicant: Nexperia B.V., 6534 AB Nijmegen (NL)
(72) Inventor: Liu, Xu, Nijmegen (NL); Wang, Ruitong, Shanghai (CN); Ti, Ching Shian, Shanghai (CN)
(74) Representative: Pjanovic, Ilija

(57) **Abstract**

The present disclosure relates to a method of manufacturing a semiconductor device, specifically of the connection of a bonding wire to a semiconductor die. In a first aspect of the disclosure, there is provided a method of manufacturing a semiconductor device, comprising the steps of:
- providing a semiconductor die onto a substrate;
- applying a paste to said semiconductor die;
- connecting a bonding wire to said paste by means of ultrasonic motion.

## Description

### Technical field

The present disclosure relates to a method of manufacturing a semiconductor device, specifically of the connection of a bonding wire to a semiconductor die.

### Background

Wire bonding is a process used in semiconductor device packaging to create electrical connections between the semiconductor die (the chip) and the external leads or substrate. This may be done using thin metal wires, most commonly made from gold, aluminum, or copper. Using copper (Cu) wire in wire bonding may offer advantages, including lower cost compared to gold, better electrical conductivity, and higher current-carrying capacity. Copper also provides superior thermal conductivity, which helps in dissipating heat more efficiently, making it ideal for high-power applications. Additionally, its mechanical strength enhances durability and reliability, especially in environments prone to mechanical stress. Copper's ability to be used in thinner wires without compromising performance supports further miniaturization of electronic components.

However, bonding process for thicker wires, especially copper, can introduce more mechanical stress on the bond pads and underlying structures of the die. The added mechanical load can cause delamination, pad lifting, or even damage to the underlying circuitry.

One approach to solve this issue is to apply a copper metallization layer during the wafer process. However, the cost may be high due to the front-end process steps including lithography, sputtering, electroplating, and etching, and the thickness of the metallization layer will be limited. Another approach is to bond an additional buffer bulk metal layer on the top surface of the chip by soldering or sintering. However, the manufacturing of such metal buffer components may require special care and this introduces an additional joining step in the method of manufacturing, which increases the process complexity.

### Summary

A summary of aspects of certain examples disclosed herein is set forth below. It should be understood that these aspects are presented merely to provide the reader with a brief summary of these certain embodiments and that these aspects are not intended to limit the scope of this disclosure. Indeed, this disclosure may encompass a variety of aspects and/or a combination of aspects that may not be set forth.

The present disclosure aims to overcome the drawbacks identified in the background section.

In a first aspect of the disclosure, there is provided a method of manufacturing a semiconductor device, comprising the steps of:
- providing a semiconductor die onto a substrate;
- applying a paste to said semiconductor die;
- connecting a bonding wire to said paste by means of ultrasonic motion.

The inventors have found that it may be beneficial to provide a method of manufacturing a semiconductor device, in particular the process of connecting a bonding wire to a semiconductor device, wherein the method is more streamlined than the prior art. Herein, as the background suggests, there is a need for a simplified connection step. The inventors have found that it may be beneficial to provide a paste on the semiconductor die. In specific, this paste is applied to the top surface of the chip. The paste may comprise separated particles, which may form a dense and complete layer after the step of connecting by means of ultrasonic motion.The paste is simple to be applied to the semiconductor die as it is a malleable substance. The paste may comprise a film, preform, ink or other paste like forms.

The step of connecting comprises providing a bonding wire in the paste, after which the bonding wire is vibrated or ultrasonically moved. This results in the forming of a dense layer on top of the semiconductor die, wherein the dense layer comprises the attached bonding wire. This therefore allows for a method of manufacturing having low constraints on the bonding process. This results in a faster process and a more streamlined process, resulting in a strong bond between the bonding wire and the semiconductor die. This may result in a structure having no die cracking issues as well as no delamination, pad lifting or damage to underlying circuitry.

In an example of the disclosure, the ultrasonic motion of the step of connecting has a duration of in between 1 µs and 1000 µs.

Due to the localized high temperature and high pressure, which may be partly due to a pressure being exerted on the paste by the bonding wire during the step of connecting, the paste may fully sinter in a short time. This is beneficial as it allows for a fast connection process.

In an example of the disclosure, prior to the step of connecting and after the step of applying a paste, the method comprises the step of drying the paste.

Drying the paste prior to the step of connecting allows the bonding process to sinter fully. Compared with the wet paste, the as-dried pad contains features: The solvent is evaporated and only the solid content remaining. If you do WB directly on the wet paste, the material has a chance to be splashing, due to the motion of bonding head. The pad is densified so it can withstand higher bonding force.

In an example of the disclosure, the paste comprises a metal sintering paste, preferably comprising copper particles.

Sintering paste is a specialized material used primarily in the manufacturing of electronic components, in this case of semiconductor devices, specifically in the connection of bonding wires to the semiconductor die. It consists of fine metallic or ceramic powder mixed with a binder to form a paste-like consistency. This mixture can be applied to the semiconductor die, where it is then subjected to heat treatment in a process known as sintering. During sintering, the paste is heated below the melting point of the primary material, causing the particles to bond together through diffusion.

By the ultrasonic motion, the temperature of the sintering paste is increased, thereby heating the sintering paste. This results in a dense, solid structure while maintaining the original shape of the applied paste.

Copper sintering paste, in particular, is a commonly used variant of the sintering paste described. It is often used due to its high thermal and electrical conductivity. The paste typically contains fine copper particles mixed with a suitable binder system, which helps in achieving the desired viscosity and application properties. During the sintering process, copper particles are bonded together at elevated temperatures, typically in a controlled atmosphere to prevent oxidation.

In an example of the disclosure, the bonding wire comprises a metal, preferably copper.

Bonding wires are wires used to establish electrical connections between the internal circuitry of semiconductor devices and the external leads or terminals of a package. Bonding wires are typically made from materials with high electrical conductivity and good mechanical properties, such as gold, aluminium, or copper.

In an example of the disclosure, the method comprises the step of applying the paste, comprising any of:
- printing;
- dispensing;
- injecting;
- spraying;
- pick-and-place.

Printing involves screen printing or inkjet printing, where the paste is transferred onto a target, in this case a semiconductor die, through a stencil or a nozzle. In screen printing, a screen is used to push the paste through a pattern, allowing for a control over the thickness and placement of the material.

Dispensing is another method used for applying sintering paste. This may involve the use of a dispenser comprising a fine nozzle. This allows for control over the amount of paste dispensed onto the semiconductor die. The paste is ejected out from the nozzle, which results in forming dots of material that can be placed directly onto the semiconductor die.

With injection, the sintering paste is forced in a specific cavity. This is designed to shape the sintering paste, hereafter the sintering paste is transferred to the semiconductor die.

Spraying involves atomizing the sintering paste into fine droplets and applying it onto the target surface, this may be beneficial to spray the overall semiconductor die and may be less precise than other methods.

Pick-and-place may be used when the paste is in the film form, which allows the paste to be applied by pick and place.

In an example of the disclosure, the paste comprises a thickness of in between 10 µm and 500 µm preferably in between 30 µm and 100 µm and even more preferably in between 50 µm and 70 µm.

During the step of connecting the bonding wire to the semiconductor die, the ultrasonic motion results in an increase of the temperature of the location. Further, this is enhanced by exerting a pressure on that location. The pressure applied may be a wedge bonding pressure. This may be beneficial as it allows for the bonding of bonding wires in densely packed circuits. Due to this increase in temperature, a buffer may be provided to shield the semiconductor die from the harmful effects of the increase in temperature. The pressure exerted on the paste and in lesser extent the semiconductor die may be high, therefore the buffering of the paste may be beneficial in easing the pressure onto the semiconductor die. Therefore the buffer may prevent damage to the semiconductor die.

In order to provide a sufficient buffer for the heat and pressure generated during this process therefore, the paste itself may be provided as a buffer. This may require the paste comprising a thickness of in between 10 µm and 100 µm preferably in between 30 µm and 85 µm and even more preferably in between 50 µm and 70 µm. This should allow the heat to be spread over the paste sufficiently, therefore not damaging the semiconductor die while also not resulting in a thick layer on top of the semiconductor die which may result in worse thermal and electric performances.

In an example of the disclosure, the step of drying comprises pre-baking the semiconductor device.

The step of drying may be by pre-baking the package. This is performed to evaporate the solvent in the paste.

In an example of the disclosure, the step of connecting comprises applying a localized increase in temperature and/or pressure.

The step of connecting comprises the ultrasonic motion, this increases the temperature and/or pressure locally. This is due to the rapid movement of the wire resulting in a large cumulative friction, which may result in heat. This heat in turn increases the temperature of the sintering paste, densifying it. This results in a strong bond between the bonding wire and the now sintered paste. The as-sintered paste will comprise high mechanical strength, high electrical conductivity and high thermal conductivity that is compatible with bulk copper material.

In an example of the disclosure, the localized increased temperature is in between 100 and 300 degrees Celsius.

The inventors have found that it may be beneficial to have the temperature increase to in between 100 and 300 degrees Celsius. This is due to the sintering process being sensitive to the temperature. An increase of the temperature results in the sintering of the paste, where the temperature resulting from the ultrasonic motion is in between 100 and 300 degrees Celsius. It should be noted that this temperature is dependent on the ultrasonic motion and therefore it is dependent on the frequency of the motion and the amplitude of the movement of the bonding wire. Both may be determined for the step in the method of manufacturing.

In an example of the disclosure, the localized increased pressure is in between 1 MPa and 200 MPa.

The inventors have found that it may be beneficial to exert a pressure of 1 MPa to 200 MPa. This may result in the increase in temperature as previously stated. Here the pressure exerted may be predefined or changed depending on the current temperature. Therefore, the control of the pressure is a factor in the control of the temperature. Both may be controlled in a control system comprising elements such as a feedback loop or feedforward control. This may be in the form of a PID controller or a MPC controller or any other suitable controller.

In an example of the disclosure, the ultrasonic motion of the step of connecting comprises any of:
- a lateral motion;
- a vertical motion, in a direction away from and towards the semiconductor die.

The ultrasonic motion may be in all kinds of directions, it could also be a rotary motion, which would fit in the category of lateral motion. The purpose of both lateral and vertical ultrasonic motion would be the creation of friction between the bonding wire and the paste, thereby increasing the temperature of the paste. As mentioned before, the pressure may impact the change in temperature. More specifically it may affect the friction between the bonding wire and the paste, which then results in an increase in temperature. Therefore, in an example of the disclosure another method of increasing the friction may be the roughening of the wire at a connection part of the bonding wire. This may similarly increase the temperature.

In an example of the disclosure, the step of connecting by means of ultrasonic motion comprises sintering the entire paste.

The inventors have found that the size of the paste may be chosen such that due to the step of connecting by ultrasonic motion the whole paste is sintered. Therefore, the size of the paste may also be very small resulting in it being compatible with the joint pad of the wire. Also, a more complex geometry of the sinter pattern may be used to for specific purposes, for example, for releasing thermal stresses, improving the thermal dissipation property of the sintered paste among others. The complex geometry may comprise a zigzag patterned paste or a paste comprising localized spots or stripes.

In an example of the disclosure the step of connecting by means of ultrasonic motion comprises sintering a connection part of the paste connected to the bonding means.

The inventors have found that a paste may be applied on the top side of the semiconductor die, thereby allowing a larger possible connection area for bonding wires to connect to. In this example, the paste is applied such that no short-circuiting of semiconductor die parts is resulted from the usage of the semiconductor package.

The bonding wire is connected at a certain part of the paste, which, due to the larger paste area, results in relaxed manufacturing tolerances.

In an example of the disclosure, the method comprises an additional step of sintering a remaining part of the paste.

The inventors have found that the remaining part of the paste, not being the connection part, may also be sintered during subsequent soldering processes assembling additional components of the semiconductor package. This may insure uniform thermal and mechanical properties across the entire interface of the sintered paste.

In an example of the disclosure, during the step of connecting, external heating is applied to the semiconductor device, thereby increasing the temperature of the paste.

The inventors have found that a background heating may be provided during the step of connecting by ultrasonic motion. Such heating assistance may improve bonding performance of the bonding wire with respectively the semiconductor die.

### Brief description of the Drawings

Embodiments of the present disclosure will now be described, by way of example only, with reference to the accompanying schematic drawings in which corresponding reference symbol indicate corresponding parts, in which:
Fig. 1 shows a method of manufacturing a semiconductor package in accordance with the disclosure.
Fig. 2 shows a semiconductor package manufactured according to the disclosure.
Fig. 3 shows an example of a semiconductor package manufactured according to the disclosure.

The figures are intended for illustrative purposes only, and do not serve as restriction of the scope of the protection as laid down by the claims.

### Detailed description

It will be readily understood that the components of the embodiments as generally described herein and illustrated in the appended figures could be arranged and designed in a wide variety of different configurations. Thus, the following more detailed description of various embodiments, as represented in the figures, is not intended to limit the scope of the present disclosure but is merely representative of various embodiments. While the various aspects of the embodiments are presented in drawings, the drawings are not necessarily drawn to scale unless specifically indicated.

The described embodiments are to be considered in all respects only as illustrative and not restrictive. The scope of the present disclosure is, therefore, indicated by the appended claims rather than by this detailed description. All changes which come within the meaning and range of equivalency of the claims are to be embraced within their scope.

Reference throughout this specification to features, advantages, or similar language does not imply that all of the features and advantages that may be realized with the present disclosure should be or are in any single example of the present disclosure. Rather, language referring to the features and advantages is understood to mean that a specific feature, advantage, or characteristic described in connection with an embodiment is included in at least one embodiment of the present disclosure. Thus, discussions of the features and advantages, and similar language, throughout this specification may, but do not necessarily, refer to the same example.

Furthermore, the described features, advantages, and characteristics of the present disclosure may be combined in any suitable manner in one or more embodiments. One skilled in the relevant art will recognize, in light of the description herein, that the present disclosure may be practiced without one or more of the specific features or advantages of a particular embodiment. In other instances, additional features and advantages may be recognized in certain embodiments that may not be present in all embodiments of the present disclosure. Reference throughout this specification to "one embodiment," "an embodiment," or similar language means that a particular feature, structure, or characteristic described in connection with the indicated embodiment is included in at least one embodiment of the present disclosure. Thus, the phrases "in one embodiment," "in an embodiment," and similar language throughout this specification may, but do not necessarily, all refer to the same embodiment.

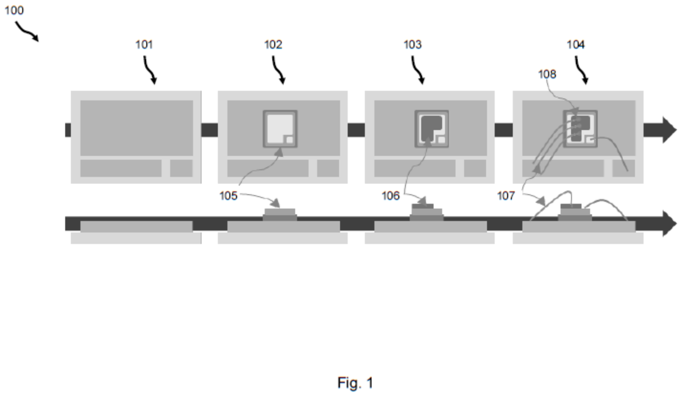

Fig. 1 shows a method of manufacturing a semiconductor package in accordance with the disclosure. In the figure there are two different view perspectives. First, the upper viewpoint is a top view of the semiconductor package and a method of manufacturing thereof. Second, the lower viewpoint is a side view of the semiconductor package and a method of manufacturing thereof. The method comprises a step 101 of providing a substrate, herein the substrate may comprise a copper baseplate or a plurality of baseplates. These may, for example, comprise terminals for the semiconductor package, or other auxiliary circuitry.

In a further step 102, the semiconductor die 105 is provided on the substrate. This may be done by soldering the semiconductor die onto the substrate. Here, the semiconductor die may comprise functional regions, such as a gate region, source region and/or drain region. These functional regions may be separated as may also be observed from the figure.

In an even further step 103, a paste 106, such as a soldering paste, may be provided on at least one of the functional regions of the semiconductor die, and at least on the semiconductor die. This sintering paste may be provided on substantially the whole of the functional region as depicted, or it may be patterned (not depicted) or it may have any other complex shape.

Hereafter, bonding wires 107 may be provided in a subsequent step 104. These bonding wires are provided and attached according to the method of the disclosure, specifically by connecting the bonding wires via ultrasonic motion. This ultrasonic motion locally heats the sintering paste, resulting in the sintering of the paste and thereby providing a firm connection between the paste and the bonding wire and therefore the bonding wire and the semiconductor die. Specifically, the location of the connection of the bonding wire with the sintering paste is fully sintered, while the other sintering paste may be sintered by an additional heating step.

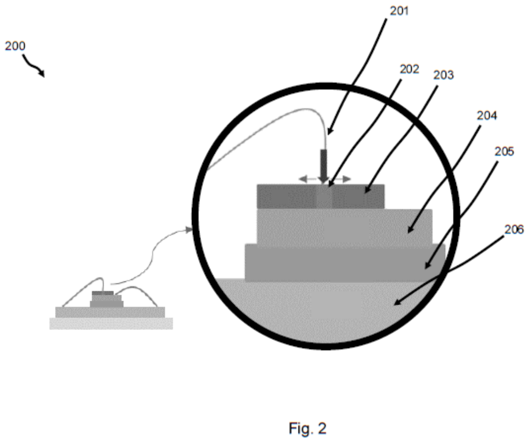

Fig. 2 shows a semiconductor package 200 manufactured according to the disclosure. Herein the step of connecting by ultrasonic motion is also depicted. Here, pressure is applied to the bonding wire 201, which allows for a facilitation of the sintering process of the ultrasonic motion. The localized connection part 202 is fully sintered by this process step, while the remaining part 203 of the sintering paste may be sintered by an additional heating step, during or after the step of connecting by ultrasonic motion. Further, the sintering paste is applied on a semiconductor die 204, which is connected by a connection means 205, such as a solder paste or any other method, to a substrate 206. The substrate may comprise a base pad, which may comprise a metallic material such as copper, which has high thermal and electric conductive properties. The bonding wire is then further connected to other parts of the semiconductor package 200.

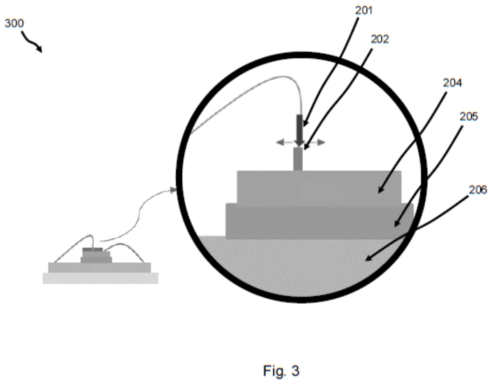

Fig. 3 shows an example of a semiconductor package 300 manufactured according to the disclosure. Herein the step of connecting by ultrasonic motion is also depicted. Here, pressure is applied to the bonding wire 201, which allows for a facilitation of the sintering process of the ultrasonic motion. The connection part 202 is fully sintered by this process step. Herein the connection part is the full sintering paste, which is carefully designed to, for example, improve the release of thermal stresses and improve thermal dissipation property.

Further, the sintering paste is applied on a semiconductor die 204, which is connected by a connection means 205, such as a solder paste or any other method, to a substrate 206. The substrate may comprise a base pad, which may comprise a metallic material such as copper, which has high thermal and electric conductive properties. The bonding wire is then further connected to other parts of the semiconductor package 200.

Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope thereof.

## Claims

1. A method of manufacturing a semiconductor device, comprising the steps of:
- providing a semiconductor die onto a substrate;
- applying a paste to said semiconductor die;
- connecting a bonding wire to said paste by means of ultrasonic motion.

2. The method according to claim 1, wherein the ultrasonic motion of the step of connecting has a duration of in between 1 µs and 1000 µs.

3. The method according to any of the previous claims, wherein prior to the step of connecting and after the step of applying a paste, the method comprises the step of drying the paste.

4. The method according to any of the previous claims, wherein the paste comprises a metal sintering paste, preferably comprising copper particles.

5. The method according to any of the previous claims, wherein the bonding wire comprises a metal, preferably copper.

6. The method according to any of the previous claims, wherein the step of applying the paste comprises any of:
- printing;
- dispensing;
- injecting;
- spraying;
- pick-and-place.

7. The method according to any of the previous claims, wherein the paste comprises a thickness of in between 10 µm and 500 µm preferably in between 30 µm and 100 µm and even more preferably in between 50 µm and 70 µm.

8. The method according to claim 3, wherein the step of drying comprises pre-baking the semiconductor device.

9. The method according to any of the previous claims, wherein the step of connecting comprises applying a localized increase in temperature and/or pressure.

10. The method according to claim 9, wherein the localized increased temperature is in between 100 and 300 degrees Celsius.

11. The method according to any of the claims 9-10, wherein the localized increased pressure is in between 1 MPa and 200 MPa.

12. The method according to any of the previous claims, wherein the ultrasonic motion of the step of connecting comprises any of:
- a lateral motion;
- a vertical motion, in a direction away from and towards the semiconductor die.

13. The method according to any of the previous claims, wherein the step of connecting by means of ultrasonic motion comprises sintering the entire paste.

14. The method according to any of the claims 1-12, wherein the step of connecting by means of ultrasonic motion comprises sintering a connection part of the paste connected to the bonding wire.

15. The method according to claim 14, wherein the method comprises an additional step of sintering a remaining part of the paste.

16. The method according to any of the previous claims, wherein during the step of connecting, external heating is applied to the semiconductor device, thereby increasing the temperature of the paste.
